# EUROPÄISCHE PATENTSCHRIFT

(11) **EP 3 421 284 B1**
(45) Veröffentlichungstag und Bekanntmachung des Hinweises auf die Patenterteilung: **30.12.2020**
(21) Anmeldenummer: 18173935.0
(22) Anmeldetag: 23.05.2018
(51) Int. Cl.: B60K 35/00, B60R 11/02, F16B 5/02

(54) **ANZEIGEVORRICHTUNG FÜR EIN KRAFTFAHRZEUG, VERFAHREN ZUR HERSTELLUNG EINER ANZEIGEVORRICHTUNG FÜR EIN KRAFTFAHRZEUG**
DISPLAY DEVICE FOR A MOTOR VEHICLE, METHOD FOR PRODUCING A DISPLAY DEVICE FOR A MOTOR VEHICLE
DISPOSITIF D'AFFICHAGE POUR UN VÉHICULE AUTOMOBILE, PROCÉDÉ DE FABRICATION D'UN DISPOSITIF D'AFFICHAGE POUR UN VÉHICULE AUTOMOBILE

(30) Priorität: 28.06.2017 DE 102017210938
(43) Veröffentlichungstag der Anmeldung: 02.01.2019
(73) Patentinhaber: VOLKSWAGEN AKTIENGESELLSCHAFT, 38440 Wolfsburg (DE)
(72) Erfinder: Krell, Thomas, 38440 Wolfsburg (DE)

(56) Entgegenhaltungen:
- DE-A1-102013 013 356
- DE-A1-102014 019 293
- JP-A- H08 268 114
- US-A1- 2016 193 923
- US-B1- 8 777 290

## Beschreibung

Die vorliegende Erfindung betrifft eine Anzeigevorrichtung für ein Kraftfahrzeug sowie ein Verfahren zur Herstellung einer Anzeigevorrichtung für ein Kraftfahrzeug, insbesondere einer Anzeigevorrichtung mit zwei oder mehr Displays. Die Erfindung betrifft weiterhin ein Kraftfahrzeug, in dem eine erfindungsgemäße Anzeigevorrichtung eingesetzt wird.

Im Zuge der zunehmenden Nutzung von Displays in Kraftfahrzeugen wird oftmals nicht mehr nur ein einzelnes Display verbaut, beispielsweise als Anzeigevorrichtung für ein Kombiinstrument, sondern eine Gruppe von Displays. So kann z.B. ein Doppeldisplay bestehend aus einem digitalen Kombiinstrument und einem Infotainmentdisplay verbaut sein.

DE 10 2013 013 356 A1 beschreibt ein Baukastensystem für eine Mehrzahl von Bauvarianten einer Instrumententafelanordnung für einen Kraftwagen. Das Baukastensystem umfasst einen bauvariantenübergreifenden Instrumentenquerträger sowie eine Mehrzahl von bauvariantenspezifischen Tafelmodulen. Die Tafelmodule sind in Abhängigkeit einer Bauvariante der Instrumententafelanordnung zusammensetzbar und können beispielsweise Bildschirme beinhalten.

US 2016/0193923 A1 beschreibt eine Anzeigeeinrichtung für ein Fahrzeug. Die Anzeigeeinrichtung umfasst eine Hauptanzeige, die an einer Vorderfläche einer Mittelverkleidung des Fahrzeugs installiert ist, um ein Bild anzuzeigen. Die Anzeigeeinrichtung umfasst zudem ein Mittelpaneel, das in einer Breitenrichtung des Hauptanzeigeteils quer über den Hauptanzeigeteil verläuft. Die Hauptanzeige ist so installiert, dass sie sich in Bezug auf die Mittelverkleidung in Richtung einer oberen Seite und unteren Seite bewegen kann. Im Fahrzeug können weitere Anzeigen vorgesehen sein.

JPH 08-268114 A beschreibt eine Anzeigevorrichtung für ein Fahrzeug, die zwei Displayeinheiten aufweist und in zwei Anzeigemodi betrieben werden kann. In einem ersten Anzeigemodus wird von beiden Displayeinheiten ein reelles Bild erzeugt. In einem zweiten Anzeigemodus erzeugt die erste Displayeinheit ein reelles Bild, während die zweite Displayeinheit ein virtuelles Bild erzeugt. Die beiden Displayeinheiten sind in einer gemeinsamen Displayanordnung in einem Armaturenbrett angeordnet. Eine optische Einheit mit einer ungeraden Anzahl von reflektierenden Spiegeln zum Reflektieren des Anzeigebildes der zweiten Displayeinheit und einem Kombinierer zum visuellen Projizieren des zweiten Anzeigebildes als virtuelles Bild ist anbringbar und abnehmbar auf der Instrumententafel vorgesehen.

US 8,777,290 B1 beschreibt eine Instrumentenanordnung für das Armaturenbrett eines Fahrzeugs. Die Instrumentenanordnung beinhaltet eine Frontplatte mit Vorder- und Rückseite und einer Öffnung für die Aufnahme eines Anzeigeinstruments, die sich durch die Frontplatte von der Vorderseite bis zur Rückseite erstreckt, eine Lehre, eine Halterung und eine Manschette. Die Manschette wird direkt an der Vorderseite der Öffnung angebracht und umschließt diese. Ein vorderes Ende des Anzeigeinstruments wird so in der Öffnung angeordnet, dass ein äußerer Rand des Anzeigeinstruments direkt an der Manschette anliegt. Die Halterung ist zwischen der Lehre und der Rückseite der Frontplatte gekoppelt, um die Manschette zwischen dem äußeren Rand der Lehre und der Vorderseite der Frontplatte zu klemmen.

Bei Doppeldisplays sollen die einzelnen Displays in der Armaturentafel des Fahrzeugs oftmals bündig nebeneinander verbaut sein und wie ein durchgehendes Displayband wirken.

Eine erste Möglichkeit dies zu erreichen besteht darin, zwei Displays hinter einem gemeinsamen Deckglas anzuordnen. Ohne weitere Maßnahmen treten durch das Deckglas allerdings Reflexionen und Doppelbilder auf, die die Ablesbarkeit der Displays stark verschlechtern. In einem gewissen Umfang kann dies durch die Verwendung eines entspiegelten Deckglases abgemildert werden.

In diesem Zusammenhang beschreibt die DE 10 2014 019 293 A1 eine Elektronikeinheit für ein Kraftfahrzeug. Die Elektronikeinheit weist ein Trägerelement, zumindest ein Anzeigemodul, das auf dem Trägerelement angeordnet ist, und ein mechanisches Verbindungselement auf, das das zumindest eine Anzeigemodul und das Trägerelement miteinander verbindet. Das mechanische Verbindungselement weist einen Verrastungsmechanismus auf.

Bessere Ergebnisse lassen sich erzielen, wenn die zwei Displays mit dem gemeinsamen Deckglas optisch gebondet, d.h. glasklar verklebt werden. Dieser Ansatz erhöht allerdings die Ausschussquote in der Produktion und verhindert eine Mehrlieferantenstrategie für die beiden Displays. Zudem müssen im Reparaturfall bei Defekten beide Displays ausgetauscht werden, was die Reparaturkosten stark erhöht.

Eine weitere Möglichkeit besteht darin, die einzelnen, jeweils mit einem Deckglas gebondeten Displays in einem gemeinsamen Trägerrahmen zu positionieren, vergleichbar mit einem Bilderrahmen. Ein bündiges Erscheinungsbild der Displays lässt sich damit allerdings nicht erreichen, da immer ein weiteres Bauteil, der Trägerrahmen, zwischen den Displays liegt. Zwar kann der Trägerrahmen farblich angepasst und möglichst flach gestaltet werden, um den Stufensprung von der Displayoberfläche zur Oberfläche des Trägerrahmens gering zu halten, es ergibt sich aber dennoch kein Erscheinungsbild wie bei einem zusammenhängenden Teil.

Schließlich können die jeweils mit einem Deckglas optisch gebondeten Displays nebeneinander an einem gemeinsamen Halter befestigt werden. Aufgrund der gegebenen Einbaubedingungen und der Toleranzen der Bauteile, insbesondere senkrecht zur Displayoberfläche, ist dies allerdings nicht prozesssicher möglich.

In Hinblick auf aus einzelnen Displays zusammengesetzte Videowände beschreibt die EP 3 029 657 A1 ein Display-System. Das Display-System umfasst eine Vielzahl von Anzeigevorrichtungen und ein Gestell, an dem die Anzeigevorrichtungen montiert sind. Das Gestell weist eine Basis auf, mit der das Gestell auf einer horizontalen Fläche aufgestellt werden kann, sowie eine Reihe von Kopplungsrahmen. Die Kopplungsrahmen sind für die Montage jeweils einer Anzeigevorrichtung ausgebildet und derart gestaltet, dass die relative Ausrichtung der Anzeigevorrichtungen eingestellt werden kann. Für die bündige Ausrichtung der Oberflächen der Anzeigevorrichtungen sind dabei drehbare Justagemuttern vorgesehen, die mit entsprechenden festen Justageschrauben zusammenwirken.

Im Hinblick auf elektronische Anzeigetafeln beschreibt die US 8,844,180 B2 ein elektronisches Schild, das aus einer Vielzahl von Rahmenschränken zusammengesetzt ist. Die Rahmenschränke sind jeweils mit horizontal oder vertikal benachbarten Rahmenschränken verbunden. Die Verbindung erfolgt dabei durch spezielle Verbindungsstücke. In den Rahmenschränken sind LED-Anzeigen montiert. Die Rahmenschränke und die Verbindungsstücke sind derart gestaltet, dass die hergestellten Verbindungen selbstausrichtend sind.

Es ist eine Aufgabe der Erfindung, eine Anzeigevorrichtung für ein Kraftfahrzeug aufzuzeigen, bei der die einzelnen Displays bündig nebeneinander verbaut sind und wie ein durchgehendes Displayband wirken. Es ist eine weitere Aufgabe der Erfindung, ein Verfahren zur Herstellung einer solchen Anzeigevorrichtung aufzuzeigen.

Diese Aufgaben werden durch eine Anzeigevorrichtung mit den Merkmalen des Anspruchs 1 und durch ein Verfahren mit den Merkmalen des Anspruchs 11 gelöst. Bevorzugte Ausgestaltungen der Erfindung sind Gegenstand der abhängigen Ansprüche.

Gemäß einem ersten Aspekt der Erfindung umfasst eine Anzeigevorrichtung zwei oder mehr nebeneinander angeordnete Displays, wobei die zwei oder mehr Displays Displaygehäuse aufweisen und mit je einem Deckglas optisch gebondet sind. Ein Halterahmen verbindet die zwei oder mehr Displays miteinander. Mittels zumindest eines in den Halterahmen oder in ein Displaygehäuse integrierten Ausgleichselementes der Anzeigevorrichtung, das eine Justagemöglichkeit bereitstellt, können die zwei oder mehr Displays relativ zueinander zumindest senkrecht zu einer Displayoberfläche ausgerichtet werden.

Gemäß einem weiteren Aspekt der Erfindung umfasst ein Verfahren zur Herstellung einer Anzeigevorrichtung mit zwei oder mehr nebeneinander angeordneten Displays für ein Kraftfahrzeug, wobei die zwei oder mehr Displays Displaygehäuse aufweisen und mit je einem Deckglas optisch gebondet sind, die Schritte:
- Befestigen eines ersten Displays an einem Halterahmen; und
- Ausrichten des ersten Displays zumindest senkrecht zu einer Displayoberfläche relativ zu einem zweiten Display, das mit dem Halterahmen verbunden ist, mittels zumindest eines in den Halterahmen oder in ein Displaygehäuse integrierten Ausgleichselements der Anzeigevorrichtung, das eine Justagemöglichkeit bereitstellt.

Die Verwendung von einem oder mehreren Ausgleichselementen ermöglicht es, Displays mit Deckglas trotz der vorhandenen Toleranzen exakt bündig nebeneinander zu verbauen. Die nahezu toleranzfreie Montage der Displays relativ zueinander bewirkt, dass die Displays wie ein zusammenhängendes Displayband wirken. Während der Montage werden die Displays vorzugsweise mittels einer Montagelehre korrekt ausgerichtet und im Anschluss mit dem Halterahmen verbunden.

Gemäß einem Aspekt der Erfindung ist jedes der zwei oder mehr Displays relativ zum Halterahmen justierbar. Auf diese Weise können nicht nur Toleranzen der einzelnen Displays relativ zueinander ausgeglichen werden, sondern auch Toleranzen des Halterahmens kompensiert werden.

Gemäß einem Aspekt der Erfindung ist zumindest eines der zwei oder mehr Displays relativ zum Halterahmen unjustierbar. In diesem Fall ist der Halterahmen entweder Bestandteil des Displaygehäuses eines der zwei oder mehr Displays oder mit dem Displaygehäuse eines der zwei oder mehr Displays unjustierbar verbunden. Das unjustierbare Display fungiert bei hierbei als Referenz für die Justage der weiteren Displays. Zwar lassen sich Toleranzen des Halterahmens bei diesem Ansatz nur noch eingeschränkt ausgleichen, im Gegenzug wird aber durch die Reduzierung der zu justierenden Elemente insgesamt die Justage vereinfacht.

Gemäß einem Aspekt der Erfindung umfasst das zumindest eine Ausgleichselement eine Gewindebuchse in einem der Displaygehäusen, in die eine Justageschraube eingreift. Vorzugsweise ist zwischen der Gewindebuchse und der Justageschraube eine Ausgleichsbuchse für den Toleranzausgleich angeordnet. Eine derartige Ausgleichsbuchse ist beispielsweise aus der EP 1 304 489 B1 bekannt. In dieser Ausführung wird eine hohe Klemmkraft und Steifigkeit der Verbindung erreicht, die das Gewicht der Komponenten auch unter dem Einfluss von Vibrationen, Temperaturschwankungen und Alterung sicher tragen kann. Weiterhin ist die Ausrichtung der Bauteile relativ zueinander senkrecht zur Displayoberfläche während des Verschraubens durch Verwendung des Ausgleichselementes automatisch möglich, was den Montageprozess verkürzt.

Gemäß einem Aspekt der Erfindung umfasst das zumindest eine Ausgleichselement eine Gewindestange mit Kontermuttern. Auch mit dieser Ausführung wird eine hohe Klemmkraft und Steifigkeit der Verbindung erreicht. Zudem lässt sich diese Ausführung besonders kostengünstig umsetzen.

Gemäß einem Aspekt der Erfindung umfasst das zumindest eine Ausgleichselement eine Befestigungslasche des Halterahmens, an der eines der Displaygehäuse seitlich befestigt wird, beispielsweise mit einer Justageschraube. Für die Justageschraube kann eine Gewindebuchse oder eine eingesetzter Mutter im Displaygehäuse vorgesehen sein. Über ein gewisses Spiel der Bohrung für die Justageschraube in der Befestigungslasche ist ein Toleranzausgleich senkrecht zur Displayoberfläche und entlang einer Achse parallel zur Displayoberfläche möglich. Gleichzeitig ist das Ausgleichselement sehr einfach gehalten, so dass es kostengünstig realisiert werden kann.

Gemäß einem Aspekt der Erfindung weisen Anlageflächen zwischen einem Displaygehäuse und dem Halterahmen eine Verklebung auf. Auf diese Weise ist eine sichere Verbindung der Komponenten über die Lebensdauer der Anzeigevorrichtung auch bei Spannkraftverlust durch Setzvorgänge gewährleistet.

Gemäß einem Aspekt der Erfindung weist der Halterahmen Befestigungspunkte für eine Armaturentafel auf. Bei dieser Lösung dient der Halterahmen nicht nur zur Verbindung der Displays miteinander, sondern gleichzeitig auch zur Befestigung der gesamten Anzeigevorrichtung in der Armaturentafel. Diese doppelte Verwendung des Halterahmens verringert die Anzahl der zu verbauenden Komponenten.

Vorzugsweise wird eine erfindungsgemäße Anzeigevorrichtung in einem Fahrzeug, insbesondere einem Kraftfahrzeug, eingesetzt.

Weitere Merkmale der vorliegenden Erfindung werden aus der nachfolgenden Beschreibung und den angehängten Ansprüchen in Verbindung mit den Figuren ersichtlich.
- Fig. 1: zeigt schematisch eine Frontansicht einer erfindungsgemäßen Anzeigevorrichtung;
- Fig. 2: zeigt schematisch eine Seitenansicht der Anzeigevorrichtung aus Fig. 1;
- Fig. 3: zeigt schematisch ein Verfahren zur Herstellung einer erfindungsgemäßen Anzeigevorrichtung;
- Fig. 4: stellt schematisch ein Kraftfahrzeug dar, in dem eine erfindungsgemäße Anzeigevorrichtung verbaut ist;
- Fig. 5: zeigt eine Frontansicht einer bevorzugten Ausführungsform der erfindungsgemäßen Anzeigevorrichtung;
- Fig. 6: zeigt eine Rückansicht der Anzeigevorrichtung aus Fig. 5;
- Fig. 7: zeigt eine Ausgestaltung eines Ausgleichselementes im Detail;
- Fig. 8: zeigt eine alternative Ausgestaltung eines Ausgleichselementes im Detail;
- Fig. 9: zeigt eine weitere alternative Ausgestaltung eines Ausgleichselementes im Detail; und
- Fig. 10: zeigt ein Detail einer weiteren bevorzugten Ausführungsform der erfindungsgemäßen Anzeigevorrichtung.

Zum besseren Verständnis der Prinzipien der vorliegenden Erfindung werden nachfolgend Ausführungsformen der Erfindung anhand der Figuren detaillierter erläutert. Es versteht sich, dass sich die Erfindung nicht auf diese Ausführungsformen beschränkt und dass die beschriebenen Merkmale auch kombiniert oder modifiziert werden können, ohne den Schutzbereich der Erfindung zu verlassen, wie er in den angehängten Ansprüchen definiert ist.

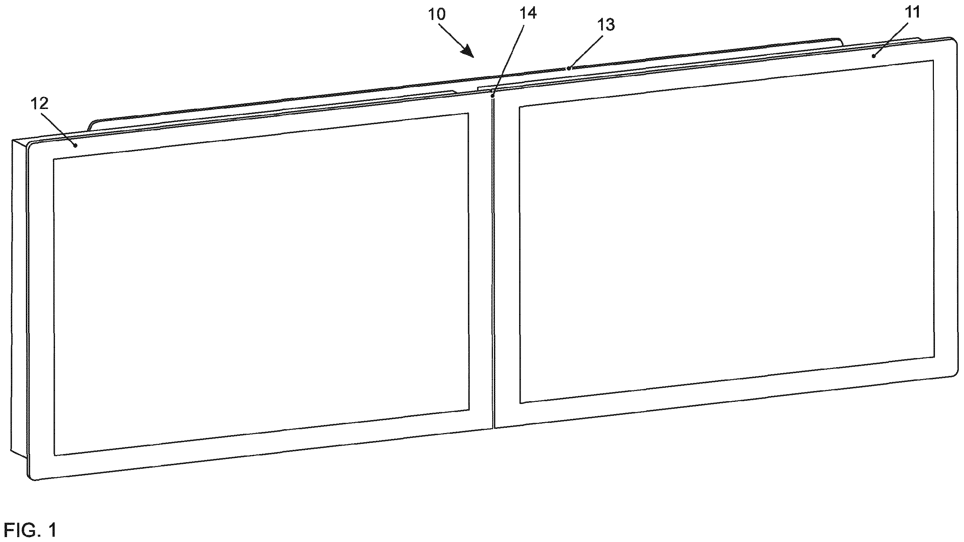

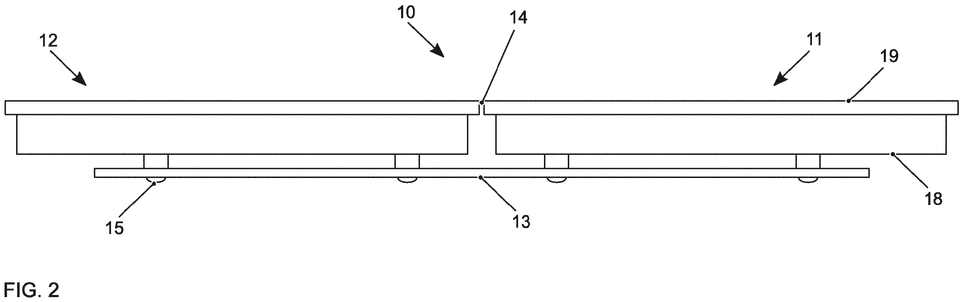

Fig. 1 zeigt schematisch eine Frontansicht einer erfindungsgemäßen Anzeigevorrichtung 10 für ein Kraftfahrzeug. Eine Seitenansicht der Anzeigevorrichtung 10 ist in Fig. 2 dargestellt. Bei der Anzeigevorrichtung 10 handelt es sich um ein Doppeldisplay umfassend ein erstes Display 11 und ein zweites Display 12. Jedes der Displays 11, 12 weist ein Displaygehäuse 18 auf und ist mit einem Deckglas 19 überbaut, das mit dem jeweiligen Display 11, 12 optisch gebondet ist. Ein Halterahmen 13, der mit den Displaygehäusen 18 verbunden ist, trägt die beiden Displays 11, 12 und verbindet sie miteinander. Mittels einer oder mehrerer Ausgleichselemente 15 ist ein Toleranzausgleich zwischen den Deckgläsern 19 möglich, d.h. die Displays 11, 12 können relativ zueinander ausgerichtet werden. Durch das Ausrichten werden ein bündiger Flächenübergang und eine gleichmäßige Fuge 14 zwischen den Deckgläsern 19 erzielt. Bei den Ausgleichselementen 15 kann es sich beispielsweise um Gewindebuchsen in den Displaygehäusen 18 handeln, die mit entsprechenden Justageschrauben zusammenwirken. In Fig. 1 und Fig. 2 können beide Displays 11, 12 relativ zum Halterahmen 13 justiert werden. Es ist aber ebenso möglich, dass eines der Displays 11, 12 ohne eine Justagemöglichkeit mit dem Halterahmen 13 verbunden ist. In diesem Fall kann der Halterahmen 13 auch ein integraler Bestandteil des entsprechenden Displaygehäuses 18 sein.

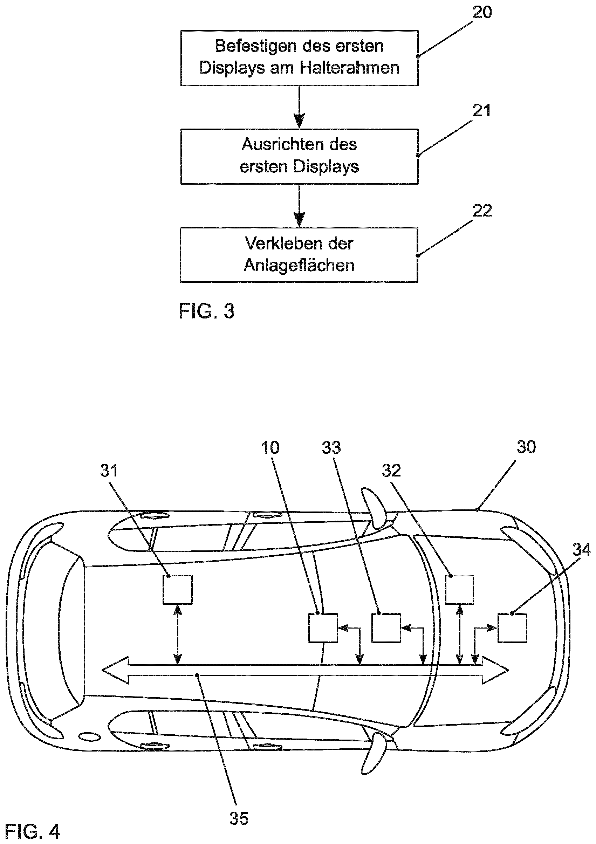

Fig. 3 zeigt schematisch ein Verfahren zur Herstellung einer Anzeigevorrichtung mit zwei oder mehr Displays für ein Kraftfahrzeug, wobei die zwei oder mehr Displays Displaygehäuse aufweisen und mit je einem Deckglas optisch gebondet sind. In einem ersten Schritt wird ein erstes Displays an einem Halterahmen befestigt 20. Anschließend wird das erste Display relativ zu einem zweiten Display, das mit dem Halterahmen verbunden ist, ausgerichtet 21. Das Ausrichten 21 erfolgt mittels zumindest eines Ausgleichselementes der Anzeigevorrichtung. Zur Sicherung der Verbindung über die Lebensdauer der Anzeigevorrichtung kann optional ein Verkleben 22 aller oder einiger Anlageflächen zwischen den Displaygehäusen und dem Halterahmen erfolgen. Das zweite Display kann justierbar oder unjustierbar mit dem Halterahmen verbunden sein. Ebenso ist es möglich, dass der Halterahmen Bestandteil des Displaygehäuses des zweiten Displays ist.

Fig. 4 stellt schematisch ein Kraftfahrzeug 30 dar, in dem eine erfindungsgemäße Anzeigevorrichtung 10 verbaut ist. Das Kraftfahrzeug 30 weist unter anderem ein Navigationssystem 31, ein Infotainmentsystem 32 und eine Grafikeinheit 33 zur Ansteuerung der Anzeigevorrichtung 10 auf. Zudem kann ein Speicher 34 vorgesehen sein. Die vom Navigationssystem 31 und dem Infotainmentsystem 32 bereitgestellten Daten werden über ein Netzwerk 35 an die Grafikeinheit 33 übermittelt. Die von der Grafikeinheit 33 generierten grafischen Anzeigen werden mittels der Anzeigevorrichtung 10 ausgegeben. In der Figur ist die Grafikeinheit 33 eine eigenständige Komponente. Sie kann allerdings auch in eine andere Komponente integriert sein, beispielsweise in das Infotainmentsystem 32 oder die Anzeigevorrichtung 10.

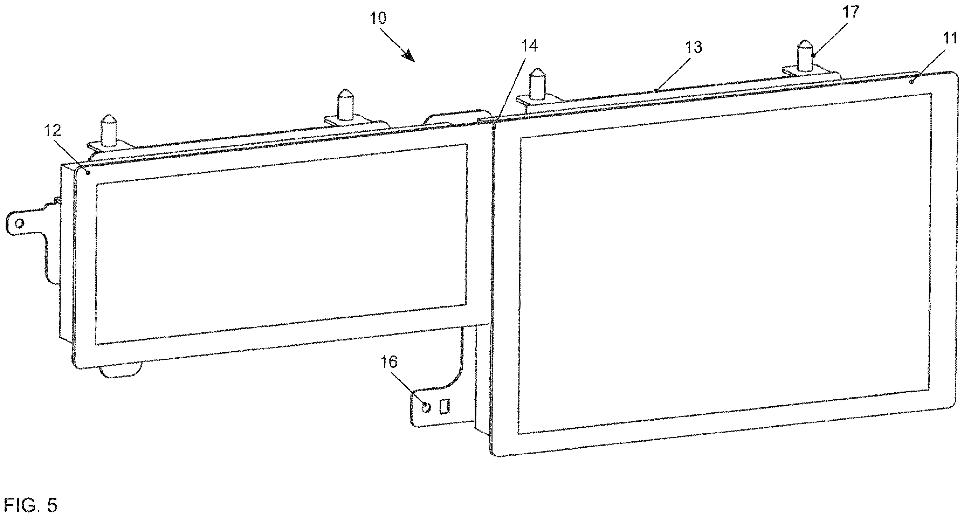

Nachfolgend sollen bevorzugte Ausführungsformen der Erfindung anhand der Figuren 5 bis 10 erläutert werden.

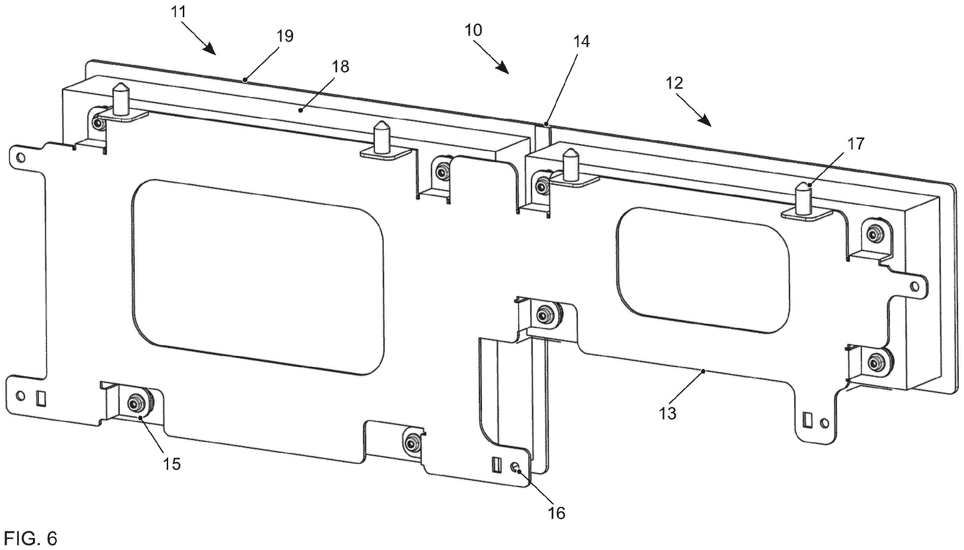

Fig. 5 zeigt eine Frontansicht, Fig. 6 die zugehörige Rückansicht einer bevorzugten Ausführungsform der erfindungsgemäßen Anzeigevorrichtung 10. In diesem Beispiel ist die Anzeigevorrichtung 10 eine Baugruppe bestehend aus einem Anzeige-Bedienteil als erstem Display 11, beispielsweise einem Infotainment-Display, und einem digitalem Kombiinstrument als zweitem Display 12. Beim digitalem Kombiinstrument kann es sich beispielsweise um ein frei programmierbares Kombiinstrument handeln. Die beiden Displays 11, 12 sind im Beispiel unterschiedlich groß, können aber selbstverständlich auch die gleiche Größe haben. Beide Displays 11, 12 sind optisch mit einem jeweiligen Deckglas 19 gebondet. Die Displaygehäuse 18 der Displays 11, 12 sind mit einem Halterahmen 13 verbunden, der die beiden Displays 11, 12 miteinander verbindet und trägt. Die beiden Displays 11, 12 und der Halterahmen 13 sind in allen Raumrichtungen toleranzbehaftet. Ein Verbau dieser Elemente mit den üblichen Zentrierungen würde dazu führen, dass die Deckgläser 19 nicht bündig zueinander stehen würden, die Fuge 14 zwischen den Geräten wäre ungleichmäßig. Um einen bündigen Flächenübergang zwischen den Glasoberflächen der Deckgläser 19 und eine gleichmäßige Fuge 14 zwischen den Deckgläsern 19 zu gewährleisten, sind die beiden Displays 11, 12 justierbar mit dem Halterahmen 13 verbunden. Eine Ausrichtung der Displays 11, 12 relativ zueinander erfolgt mittels Ausgleichselementen 15. Für den Einbau im Kraftfahrzeug weist der Halterahmen eine Reihe von Befestigungspunkten 16 auf, mit deren Hilfe der Halterahmen 13 mit einer Instrumententafel verbunden werden kann. Zudem können Montagezapfen 17 zur Erleichterung der Montage vorgesehen sein.

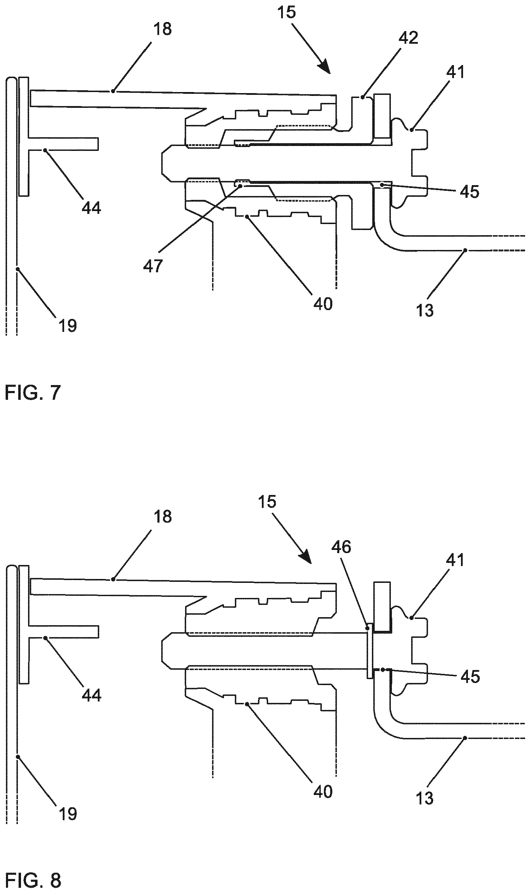

Fig. 7 zeigt eine beispielhafte Ausgestaltung eines Ausgleichselementes 15 im Detail. Das Deckglas 19 wird von einem Displayträger 44 gehalten, der mit dem Displaygehäuse 18 verbunden ist. In das Displaygehäuse 18 ist eine umspritzte Gewindebuchse 40 eingelassen, in die eine Justageschraube 41 eingreift. Zwischen der Justageschraube 41 und der Gewindebuchse 40 befindet sich eine Ausgleichsbuchse 42. Mittels der Justageschraube 41 und der Ausgleichsbuchse 42 ist das Displaygehäuse 18 am Halterahmen 13 befestigt. Die Ausgleichsbuchse 42 hat ein linksgängiges Außengewinde, das mit einem entsprechenden Innengewinde der Gewindebuchse 40 zusammenwirkt. Die Ausgleichsbuchse 42 hat zudem einen Klemmabschnitt 47, der mit der Justageschraube 41 durch Reibschluss verbunden ist und bei Überwindung des Reibschlusses relativ zur Justageschraube 41 drehbar ist. Beim Einschrauben dreht die Justageschraube 41 somit die Ausgleichsbuchse 42 durch Reibschluss mit, wodurch sich die Ausgleichsbuchse 42 entgegen der Einsteckrichtung aus der Gewindebuchse 40 herausdreht. Sobald sich die Ausgleichsbuchse 42 an den Halterahmen 13 angelegt hat, wird der Reibschluss überwunden und die Justageschraube 41 geht mit einem rechtsgängigen Innengewinde der Gewindebuchse 40 oder der Ausgleichsbuchse 42 eine Schraubverbindung ein. Auf diese Weise wird ein Toleranzausgleich senkrecht zur Displayoberfläche ermöglicht. Beispielsweise kann ein Einstellweg von ±2mm vorgesehen sein. Zudem wird durch ein Spiel der Bohrung 45 für die Justageschraube 41 im Halterahmen 13 eine Ausrichtung des Displays parallel zur Displayoberfläche ermöglicht. Alternativ zur Kombination aus Gewindebuchse 40 und Justageschraube 41 kann das Ausgleichselement 15 auch durch Gewindestangen und Kontermuttern gebildet werden.

Fig. 8 zeigt eine alternative Ausgestaltung eines Ausgleichselementes 15. Wiederum wird das Deckglas 19 von einem Displayträger 44 gehalten, der mit dem Displaygehäuse 18 verbunden ist. In das Displaygehäuse 18 ist eine umspritzte Gewindebuchse 40 eingelassen, in die eine Justageschraube 41 eingreift. Die Bohrung 45 ist bei dieser Ausgestaltung weitgehend ohne Spiel ausgebildet. Die Justageschraube 41 wird von einem Sprengring 46 fixiert. Das Displaygehäuse 18 wird durch die Justageschraube 41 relativ zum Halterahmen 13 gehalten. Auch auf diese Weise wird ein Toleranzausgleich senkrecht zur Displayoberfläche ermöglicht. Beispielsweise kann ein Einstellweg von ±2mm vorgesehen sein.

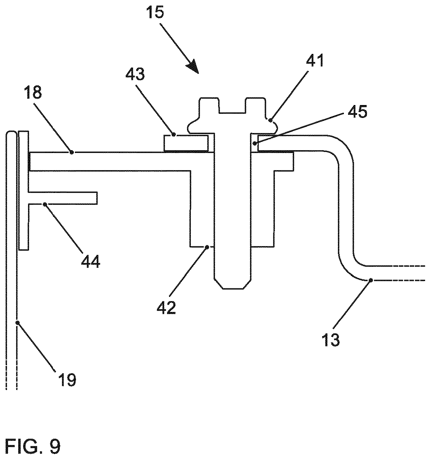

Fig. 9 zeigt eine weitere alternative Ausgestaltung eines Ausgleichselementes 15. Wie zuvor wird das Deckglas 19 von einem Displayträger 44 gehalten, der mit dem Displaygehäuse 18 verbunden ist. In diesem Beispiel wird die einstellbare Verbindung zwischen dem Display und dem Halterahmen 13 über eine Befestigungslasche 43 erreicht, die mit einer Justageschraube 41 seitlich am Displaygehäuse 18 verschraubt wird. Zu diesem Zweck kann für die Justageschraube 41 eine Gewindebuchse oder eine eingesetzter Mutter im Displaygehäuse 18 vorgesehen sein. Über ein gewisses Spiel der Bohrung 45 für die Justageschraube 41 in der Befestigungslasche 43 ist ein Toleranzausgleich senkrecht zur Displayoberfläche und entlang einer Achse parallel zur Displayoberfläche möglich.

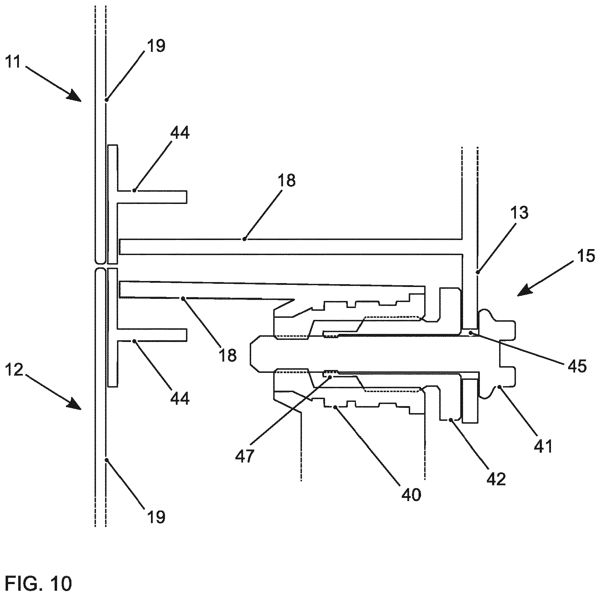

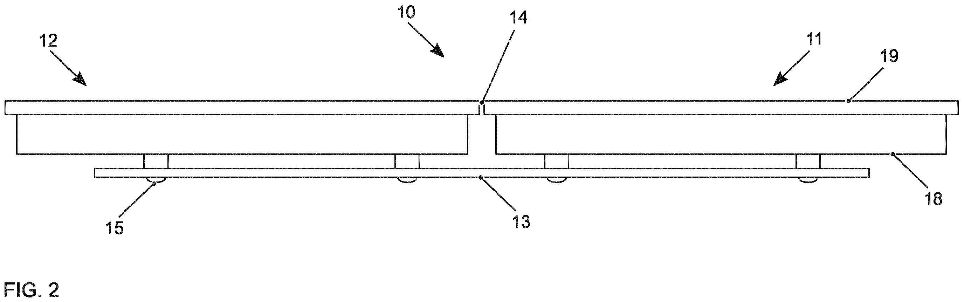

Fig. 10 zeigt ein Detail einer weiteren bevorzugten Ausführungsform der erfindungsgemäßen Anzeigevorrichtung. In dieser Ausführungsform ist der Halterahmen 13 in das Displaygehäuse 18 des ersten Displays 11 integriert, d.h. das erste Display 11 kann nicht justiert werden. Die Deckgläser 19 werden von zugehörigen Displayträgern 44 gehalten, die mit den Displaygehäusen 18 verbunden sind. In das Displaygehäuse 18 des zweiten Displays 12 ist eine umspritzte Gewindebuchse 40 eingelassen, in die wiederum eine Justageschraube 41 eingreift. Zwischen der Justageschraube 41 und der Gewindebuchse 40 befindet sich die bereits aus Fig. 7 bekannte Ausgleichsbuchse 42. Mittels der Justageschraube 41 und der Ausgleichsbuchse 42 ist das Displaygehäuse 18 des zweiten Displays 12 am Halterahmen 13 befestigt. Auf diese Weise wird ein Toleranzausgleich des zweiten Displays 12 relativ zum ersten Display 11 senkrecht zur Displayoberfläche ermöglicht. Beispielsweise kann auch hier ein Einstellweg von ±2mm vorgesehen sein. Zudem wird durch ein Spiel der Bohrung 45 für die Justageschraube 41 im Halterahmen 13 eine Ausrichtung des zweiten Displays 12 relativ zum ersten Display 11 parallel zur Displayoberfläche ermöglicht.

### Bezugszeichenliste

- 10: Anzeigevorrichtung
- 11: Erstes Display
- 12: Zweites Display
- 13: Halterahmen
- 14: Fuge
- 15: Ausgleichselement
- 16: Befestigungspunkt
- 17: Montagezapfen
- 18: Displaygehäuse
- 19: Deckglas
- 20: Befestigen des ersten Displays am Halterahmen
- 21: Ausrichten des ersten Displays
- 22: Verkleben der Anlageflächen
- 30: Kraftfahrzeug
- 31: Navigationssystem
- 32: Infotainmentsystem
- 33: Grafikeinheit
- 34: Speicher
- 35: Netzwerk
- 40: Gewindebuchse
- 41: Justageschraube
- 42: Ausgleichsbuchse
- 43: Befestigungslasche
- 44: Displayträger
- 45: Bohrung
- 46: Sprengring
- 47: Klemmabschnitt

## Patentansprüche

1. Anzeigevorrichtung (10) für ein Kraftfahrzeug (30), mit:
- zwei oder mehr nebeneinander angeordneten Displays (11, 12), wobei die zwei oder mehr Displays (11, 12) Displaygehäuse (18) aufweisen und mit je einem Deckglas (19) optisch gebondet sind; und
- einem Halterahmen (13), der die zwei oder mehr Displays (11, 12) miteinander verbindet;
**dadurch gekennzeichnet, dass** die Anzeigevorrichtung (10) zumindest ein in den Halterahmen (13) oder in ein Displaygehäuse (18) integriertes Ausgleichselement (15) mit einer Justagemöglichkeit zum Ausrichten der zwei oder mehr Displays (11, 12) relativ zueinander zumindest senkrecht zu einer Displayoberfläche aufweist.

2. Anzeigevorrichtung (10) gemäß Anspruch 1, wobei jedes der zwei oder mehr Displays (11, 12) relativ zum Halterahmen (13) justierbar ist.

3. Anzeigevorrichtung (10) gemäß Anspruch 1, wobei zumindest eines der zwei oder mehr Displays (11, 12) relativ zum Halterahmen (13) unjustierbar ist.

4. Anzeigevorrichtung (10) gemäß Anspruch 3, wobei der Halterahmen (13) Bestandteil des Displaygehäuses (18) eines der zwei oder mehr Displays (11, 12) ist oder mit dem Displaygehäuse (18) eines der zwei oder mehr Displays (11, 12) unjustierbar verbunden ist.

5. Anzeigevorrichtung (10) gemäß einem der Ansprüche 1 bis 4, wobei das zumindest eine Ausgleichselement (15) eine Gewindebuchse (40) in einem der Displaygehäusen (18) umfasst, in die eine Justageschraube (41) eingreift.

6. Anzeigevorrichtung (10) gemäß Anspruch 5, wobei zwischen der Gewindebuchse (40) und der Justageschraube (41) eine Ausgleichsbuchse (42) angeordnet ist.

7. Anzeigevorrichtung (10) gemäß einem der Ansprüche 1 bis 4, wobei das zumindest eine Ausgleichselement (15) eine Gewindestange mit Kontermuttern umfasst.

8. Anzeigevorrichtung (10) gemäß einem der Ansprüche 1 bis 4, wobei das zumindest eine Ausgleichselement (15) eine Befestigungslasche (43) des Halterahmens (13) umfasst, an der eines der Displaygehäuse (18) seitlich befestigt wird.

9. Anzeigevorrichtung (10) gemäß einem der vorherigen Ansprüche, wobei Anlageflächen zwischen einem Displaygehäuse (18) und dem Halterahmen (13) eine Verklebung aufweisen.

10. Anzeigevorrichtung (10) gemäß einem der vorherigen Ansprüche, wobei der Halterahmen (13) Befestigungspunkte (16) für eine Armaturentafel aufweist.

11. Verfahren zur Herstellung einer Anzeigevorrichtung (10) mit zwei oder mehr nebeneinander angeordneten Displays (11, 12) für ein Kraftfahrzeug (30), wobei die zwei oder mehr Displays (11, 12) Displaygehäuse (18) aufweisen und mit je einem Deckglas (19) optisch gebondet sind, mit den Schritten:
- Befestigen (20) eines ersten Displays (11) an einem Halterahmen (13); und
- Ausrichten (21) des ersten Displays (11) zumindest senkrecht zu einer Displayoberfläche relativ zu einem zweiten Display (12), das mit dem Halterahmen (13) verbunden ist, mittels zumindest eines in den Halterahmen (13) oder in ein Displaygehäuse (18) integrierten Ausgleichselementes (15) der Anzeigevorrichtung (10), das eine Justagemöglichkeit bereitstellt.

12. Verfahren gemäß Anspruch 11, wobei Anlageflächen zwischen einem Displaygehäuse (18) und dem Halterahmen (13) verklebt (22) werden.

13. Kraftfahrzeug (30), **dadurch gekennzeichnet, dass** es eine Anzeigevorrichtung (10) gemäß einem der Ansprüche 1 bis 10 aufweist.

## Claims

1. Display device (10) for a motor vehicle (30), comprising:
- two or more displays (11, 12) arranged next to one another, wherein the two or more displays (11, 12) have display housings (18) and are optically bonded to a respective cover glass (19); and
- a holding frame (13) connecting the two or more displays (11, 12) with one another;
**characterized in that** the display device (10) has at least one compensating element (15) integrated into the holding frame (13) or into a display housing (18), with an adjustment capability for aligning the two or more displays (11, 12) relative to one another at least perpendicular to a display surface.

2. Display device (10) according to claim 1, wherein each of the two or more displays (11, 12) can be adjusted relative to the holding frame (13).

3. Display device (10) according to claim 1, wherein at least one of the two or more displays (11, 12) cannot be adjusted relative to the holding frame (13).

4. Display device (10) according to claim 3, wherein the holding frame (13) is part of the display housing (18) of one of the two or more displays (11, 12), or is connected to the display housing (18) of one of the two or more displays (11, 12) so as to be unadjustable.

5. Display device (10) according to one of claims 1 to 4, wherein, in one of the display housings (18), the at least one compensating element (15) comprises a threaded bushing (40) in which an adjustment screw (41) engages.

6. Display device (10) according to claim 5, wherein a compensating bushing (42) is arranged between the threaded bushing (40) and the adjustment screw (41).

7. Display device (10) according to one of claims 1 to 4, wherein the at least one compensating element (15) comprises a threaded rod with lock nuts.

8. Display device (10) according to one of the claims 1 to 4, wherein the at least one compensating element (15) comprises a fastening tab (43) of the holding frame (13) to which one of the display housings (18) is fastened laterally.

9. Display device (10) according to one of the preceding claims, wherein contact surfaces between a display housing (18) and the holding frame (13) have an adhesive bond.

10. Display device (10) according to one of the preceding claims, wherein the holding frame (13) has attachment points (16) for a dashboard.

11. Method for producing a display device (10) comprising two or more displays (11, 12) arranged next to one another for a motor vehicle (30), wherein the two or more displays (11, 12) have display housings (18) and are optically bonded to a respective cover glass (19), comprising the steps:
- attaching (20) a first display (11) to a holding frame (13); and
- aligning (21) the first display (11) at least perpendicular to a display surface, relative to a second display (12) which is connected to the holding frame (13), by means of at least one compensating element (15) of the display device (10), said compensating element being integrated into the holding frame (13) or into a display housing (18), which provides an adjustment capability.

12. Method according to claim 11, wherein contact surfaces between a display housing (18) and the holding frame (13) are glued (22).

13. Motor vehicle (30), **characterized in that** it comprises a display device (10) according to any one of claims 1 to 10.

## Revendications

1. Dispositif d'affichage (10) pour un véhicule automobile (30), comprenant :
- au moins deux affichages (11, 12) disposés adjacents, dans lequel les au moins deux affichages (11, 12) comportent un boîtier d'affichage (18) et sont respectivement liés optiquement à un verre de recouvrement (19) ; et
- un cadre de maintien (13), lequel relie les au moins deux affichages (11, 12) ;
**caractérisé en ce que** le dispositif d'affichage (10) comporte au moins un élément de compensation (15) intégré dans le cadre de maintien (13) ou dans un boîtier d'affichage (18) avec une possibilité d'ajustage d'orientation des au moins deux affichages (11, 12) l'un par rapport à l'autre, au moins perpendiculairement à une surface d'affichage.

2. Dispositif d'affichage (10) selon la revendication 1, dans lequel chacun des au moins deux affichages (11, 12) est ajustable par rapport au cadre de maintien (13).

3. Dispositif d'affichage (10) selon la revendication 1, dans lequel l'au moins un des au moins deux affichages (11, 12) est non ajustable par rapport au cadre de maintien (13).

4. Dispositif d'affichage (10) selon la revendication 3, dans lequel le cadre de maintien (13) est partie intégrante du boîtier d'affichage (18) de l'un des au moins deux affichages (11, 12) ou est raccordé de manière non ajustable au boîtier d'affichage (18) de l'un des au moins deux affichages (11, 12).

5. Dispositif d'affichage (10) selon l'une quelconque des revendications 1 à 4, dans lequel l'au moins un élément de compensation (15) comprend une douille filetée (40) dans l'un des boîtiers d'affichage (18), dans laquelle une vis d'ajustage (41) vient en prise.

6. Dispositif d'affichage (10) selon la revendication 5, dans lequel une douille de compensation (42) est disposée entre la douille filetée (40) et la vis d'ajustage (41).

7. Dispositif d'affichage (10) selon l'une quelconque des revendications 1 à 4, dans lequel l'au moins un élément de compensation (15) comprend une tige filetée dotée des contre-écrous.

8. Dispositif d'affichage (10) selon l'une quelconque des revendications 1 à 4, dans lequel l'au moins un élément de compensation (15) comprend un axe de fixation (43) du cadre de maintien (13), sur lequel l'un des boîtiers d'affichage (18) est fixé latéralement.

9. Dispositif d'affichage (10) selon l'une quelconque des revendications précédentes, dans lequel des surfaces d'appui entre un boîtier d'affichage (18) et le cadre de maintien (13) comportent une adhérence.

10. Dispositif d'affichage (10) selon l'une quelconque des revendications précédentes, dans lequel le cadre de maintien (13) comporte des points de fixation (16) pour un tableau de bord.

11. Procédé de fabrication d'un dispositif d'affichage (10) comprenant au moins deux affichages (11, 12) disposés adjacents pour un véhicule automobile (30), dans lequel les au moins deux affichages (11, 12) comportent un boîtier d'affichage (18) et sont respectivement liés optiquement à un verre de recouvrement (19), comprenant les étapes suivantes :
- la fixation (20) d'un premier affichage (11) sur un cadre de maintien (13) ; et
- l'orientation (21) du premier affichage (11) au moins perpendiculairement à une surface d'affichage par rapport à un second affichage (12), lequel est raccordé au cadre de maintien (13), au moyen d'au moins un élément de compensation (15) du dispositif d'affichage (10) intégré dans le cadre de maintien (13) ou dans un boîtier d'affichage (18), lequel fournit une possibilité d'ajustage.

12. Procédé selon la revendication 11, dans lequel des surfaces d'affichage sont collées (22) entre un boîtier d'affichage (18) et le cadre de maintien (13).

13. Véhicule automobile (30), **caractérisé en ce qu'**il comporte un dispositif d'affichage (10) selon l'une quelconque des revendications 1 à 10.
